# FASCICULE DE BREVET EUROPEEN

(11) **EP 3 776 668 B1**
(45) Date de publication et mention de la délivrance du brevet: **29.06.2022**
(21) Numéro de dépôt: 19730402.5
(22) Date de dépôt: 16.05.2019
(51) Int. Cl.: H01L 31/049, H01L 31/048

(54) **MODULE PHOTOVOLTAÏQUE LÉGER ET FLEXIBLE COMPORTANT UNE COUCHE AVANT EN POLYMÈRE ET UNE COUCHE ARRIÈRE EN MATÉRIAU COMPOSITE**
LEICHTGEWICHTIGES UND FLEXIBLES PHOTOVOLTAISCHES MODUL MIT EINER VORDEREN SCHICHT AUS EINEM POLYMER UND EINER HINTEREN SCHICHT AUS EINEM VERBUNDWERKSTOFF
LIGHTWEIGHT AND FLEXIBLE PHOTOVOLTAIC MODULE COMPRISING A FRONT LAYER CONSISTING OF A POLYMER AND A REAR LAYER CONSISTING OF A COMPOSITE MATERIAL

(30) Priorité: 22.05.2018 FR 1854260
(43) Date de publication de la demande: 17.02.2021
(73) Titulaire: Commissariat à l'énergie atomique et aux énergies alternatives, 75015 Paris (FR)
(72) Inventeur: GAUME, Julien, 38054 Grenoble Cedex 09 (FR); GUERIN, Thomas, 38054 Grenoble Cedex 09 (FR); VESCHETTI, Yannick, 38054 Grenoble Cedex 09 (FR)
(74) Mandataire: Brevalex
(86) Numéro de dépôt international: PCT/FR2019/051114
(87) Numéro de publication internationale: WO 2019/224458

(56) Documents cités:
- EP-A1- 2 623 314
- EP-A1- 2 660 876
- WO-A1-2010/019829
- WO-A1-2018/060611
- CN-B- 105 322 039
- US-A1- 2007 012 353

## Description

### DOMAINE TECHNIQUE

La présente invention se rapporte au domaine des modules photovoltaïques, qui comportent un ensemble de cellules photovoltaïques reliées entre elles électriquement, et préférentiellement des cellules photovoltaïques dites « cristallines », c'est-à-dire qui sont à base de silicium monocristallin ou multicristallin.

L'invention peut être mise en œuvre pour de nombreuses applications, par exemple des applications autonomes et/ou embarquées, étant particulièrement concernée par les applications qui requièrent l'utilisation de modules photovoltaïques flexibles, sans verre et ultra-légers, en particulier d'un poids par unité de surface inférieur à 1 kg/m², et notamment inférieur à 800 g/m², voire encore inférieur à 600 g/m², et de faible épaisseur, notamment inférieure à 1 mm. Elle peut ainsi notamment être appliquée pour des bâtiments tels que des habitats ou locaux industriels (tertiaires, commerciaux, ...), par exemple pour la réalisation de leurs toitures, pour la conception de mobilier urbain, par exemple pour de l'éclairage public, la signalisation routière ou encore la recharge de voitures électriques, voire également être utilisée pour des applications nomades, en particulier pour une intégration sur des voitures, bus ou bateaux, entre autres.

L'invention propose ainsi un module photovoltaïque ultra-léger et flexible comportant une première couche formant la face avant du module, en matériau polymère, et une deuxième couche, en matériau composite, ainsi qu'un procédé de réalisation d'un tel module photovoltaïque.

### ÉTAT DE LA TECHNIQUE ANTÉRIEURE

Un module photovoltaïque est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, présentant une épaisseur typiquement comprise entre 2 et 4 mm, classiquement de l'ordre de 3 mm.

La deuxième couche formant la face arrière du module photovoltaïque peut quant à elle être réalisée à base de verre, de métal ou de plastique, entre autres. Elle est souvent formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 400 µm.

Les cellules photovoltaïques peuvent être reliées électriquement entre elles par des éléments de contact électrique avant et arrière, appelés conducteurs de liaison, et formés par exemple par des bandes de cuivre étamé, respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques, ou bien encore uniquement en face arrière pour les cellules photovoltaïques de type IBC (pour « Interdigitated Back Contact » en anglais).

Il est à noter que les cellules photovoltaïques de type IBC (« Interdigitated Back Contact ») sont des structures pour lesquelles les contacts sont réalisés sur la face arrière de la cellule en forme de peignes interdigités. Elles sont par exemple décrites dans le brevet américain US 4,478,879 A.

Par ailleurs, les cellules photovoltaïques, situées entre les première et deuxième couches formant respectivement les faces avant et arrière du module photovoltaïque, peuvent être encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'encapsulant peut présenter une épaisseur d'au moins 0,2 mm et un module de Young typiquement compris entre 2 et 400 MPa à température ambiante.

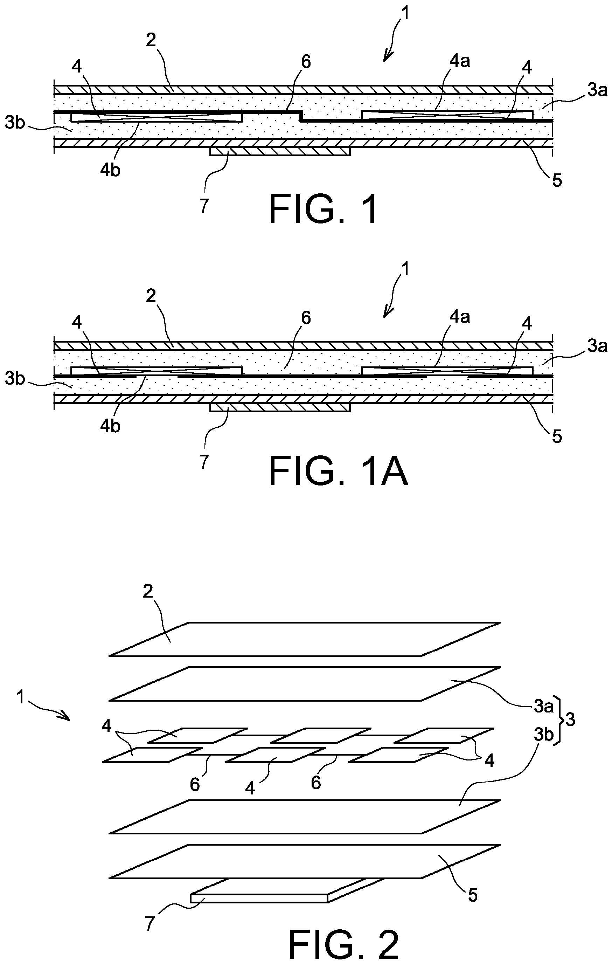

On a ainsi représenté partiellement et schématiquement, respectivement en coupe sur la figure 1 et en vue éclatée sur la figure 2, un exemple classique de module photovoltaïque 1 comportant des cellules photovoltaïques 4 cristallines.

Comme décrit précédemment, le module photovoltaïque 1 comporte une face avant 2, généralement réalisée en verre trempé transparent d'épaisseur d'environ 3 mm, et une face arrière 5, par exemple constituée par une feuille polymère, opaque ou transparente, monocouche ou multicouche, ayant un module de Young supérieur à 400 MPa à température ambiante.

Entre les faces avant 2 et arrière 5 du module photovoltaïque 1 se situent les cellules photovoltaïques 4, reliées électriquement entre elles par des conducteurs de liaison 6 et immergées entre deux couches avant 3a et arrière 3b de matériau d'encapsulation formant toutes les deux un ensemble encapsulant 3.

La figure 1A représente en outre une variante de réalisation de l'exemple de la figure 1 dans laquelle les cellules photovoltaïques 4 sont de type IBC, les conducteurs de liaison 6 étant uniquement disposés contre les faces arrières des cellules photovoltaïques 4.

Par ailleurs, les figures 1 et 2 représentent également la boîte de jonction 7 du module photovoltaïque 1, destinée à recevoir le câblage nécessaire à l'exploitation du module. Classiquement, cette boîte de jonction 7 est réalisée en plastique ou en caoutchouc, et présente une étanchéité complète.

De façon habituelle, le procédé de réalisation du module photovoltaïque 1 comporte une étape dite de lamination sous vide des différentes couches décrites précédemment, à une température supérieure ou égale à 120°C, voire 140°C, voire encore 150°C, et inférieure ou égale à 170°C, typiquement comprise entre 145 et 160°C, et pendant une durée du cycle de lamination d'au moins 10 minutes, voire 15 minutes.

Pendant cette étape de lamination, les couches de matériau d'encapsulation 3a et 3b fondent et viennent englober les cellules photovoltaïques 4, en même temps que l'adhérence se crée à toutes les interfaces entre les couches, à savoir entre la face avant 2 et la couche avant de matériau d'encapsulation 3a, la couche de matériau d'encapsulation 3a et les faces avant 4a des cellules photovoltaïques 4, les faces arrière 4b des cellules photovoltaïques 4 et la couche arrière de matériau d'encapsulation 3b, et la couche arrière de matériau d'encapsulation 3b et la face arrière 5 du module photovoltaïque 1. Le module photovoltaïque 1 obtenu est ensuite encadré, typiquement par le biais d'un profilé en aluminium.

Une telle structure est maintenant devenue un standard qui possède une résistance mécanique importante grâce à l'utilisation d'une face avant 2 en verre épais et du cadre aluminium, lui permettant, notamment et dans la majorité des cas, de respecter les normes IEC 61215 et IEC 61730.

Néanmoins, un tel module photovoltaïque 1 selon la conception classique de l'art antérieur présente l'inconvénient d'avoir un poids élevé, en particulier un poids par unité de surface d'environ 12 kg/m², et n'est ainsi pas adapté pour certaines applications pour lesquelles la légèreté est une priorité.

Ce poids élevé du module photovoltaïque 1 provient principalement de la présence du verre épais, avec une épaisseur d'environ 3 mm, pour former la face avant 2, la densité du verre étant en effet élevée, de l'ordre de 2,5 kg/m²/mm d'épaisseur, et du cadre aluminium. Pour pouvoir résister aux contraintes lors de la fabrication et également pour des raisons de sécurité, par exemple du fait du risque de coupure, le verre est trempé. Or, l'infrastructure industrielle de la trempe thermique est configurée pour traiter du verre d'au moins 3 mm d'épaisseur. En outre, le choix d'avoir une épaisseur de verre d'environ 3 mm est également lié à une résistance mécanique à la pression normée de 5,4 kPa. En définitif, le verre représente ainsi à lui seul pratiquement 70 % du poids du module photovoltaïque 1, et plus de 80 % avec le cadre en aluminium autour du module photovoltaïque 1.

Aussi, afin d'obtenir une réduction significative du poids d'un module photovoltaïque pour permettre son utilisation dans de nouvelles applications exigeantes en termes de légèreté et de mise en forme, il existe un besoin pour trouver une solution alternative à l'utilisation d'un verre épais en face avant du module. Une des problématiques consiste donc à remplacer la face avant en verre par de nouveaux matériaux plastiques tout en conservant l'architecture et la méthode de mise en œuvre habituelles avec pour but premier la diminution importante du poids surfacique.

Ainsi, des feuilles de polymères, comme le polycarbonate (PC), le polyméthacrylate de méthyle (PMMA), le polyfluorure de vinylidène (PVDF), l'éthylène tétrafluoroéthylène (ETFE), l'éthylène chlorotrifluoroéthylène (ECTFE), ou l'éthylène propylène fluoré (FEP), peuvent représenter une alternative au verre. Cependant, lorsque seul le remplacement du verre par une telle feuille mince de polymères est envisagé, la cellule photovoltaïque devient très vulnérable au choc et à la charge mécanique.

Le remplacement du verre en face avant des modules photovoltaïques a fait l'objet de plusieurs brevets ou demandes de brevet dans l'art antérieur. On peut ainsi citer à ce titre les demandes de brevet FR 2 955 051 A1, US 2005/0178428 A1, CN 105 322 039 B, EP 2 660 876 A1, EP 2 623 314 A1,

WO 2008/019229 A2 et WO 2012/140585 A1.

Les modules photovoltaïques obtenus, légers et flexibles, possèdent un poids surfacique, typiquement inférieur ou égal à 6 kg/m², très inférieur à celui des modules photovoltaïques classiquement réalisés avec du verre épais en face avant. Cependant, leur poids surfacique n'atteint que très rarement un poids surfacique inférieur à 1kg/m².

### EXPOSÉ DE L'INVENTION

Il existe ainsi un besoin pour concevoir une solution alternative de module photovoltaïque prévu pour être flexible et ultra-léger afin de s'adapter à certaines applications, tout en présentant des propriétés mécaniques suffisantes lui permettant d'être résistant aux chocs et à la charge mécanique, et en particulier aux normes IEC 61215 et IEC 61730.

L'invention a donc pour but de remédier au moins partiellement aux besoins mentionnés précédemment et aux inconvénients relatifs aux réalisations de l'art antérieur.

L'invention a ainsi pour objet, selon l'un de ses aspects, un module photovoltaïque comportant :
- une première couche transparente formant la face avant du module photovoltaïque, destinée à recevoir un flux lumineux,
- une pluralité de cellules photovoltaïques disposées côte à côte et reliées électriquement entre elles,
- un ensemble encapsulant la pluralité de cellules photovoltaïques,
- une deuxième couche, l'ensemble encapsulant et la pluralité de cellules photovoltaïques étant situés entre les première et deuxième couches.

La première couche comporte au moins un matériau polymère et présente une épaisseur inférieure à 50 µm, et avantageusement comprise entre 5 µm et 25 µm. Elle est avantageusement constituée par ledit au moins un matériau polymère.

De plus, la deuxième couche comporte au moins un matériau composite de type préimprégné à base de résine polymère et de fibres, et elle présente un poids surfacique inférieur à 150 g/m², et avantageusement compris entre 50 g/m² et 115 g/m². Elle peut être par exemple constituée par ledit au moins un matériau composite.

En outre, l'ensemble encapsulant présente une épaisseur maximale inférieure à 150 µm.

Le module photovoltaïque peut en outre comporter une couche additionnelle, formant la face arrière du module photovoltaïque, la deuxième couche étant située entre la couche additionnelle et l'ensemble encapsulant.

La couche additionnelle peut être constituée par le même matériau que celui constituant la première couche formant la face avant du module photovoltaïque, ce matériau étant préférentiellement de l'éthylène chlorotrifluoroéthylène (ECTFE), également connu sous le nom Halar^{®}.

De préférence, la couche additionnelle peut présenter une épaisseur inférieure ou égale à celle de la première couche.

La couche additionnelle peut avantageusement permettre une isolation diélectrique du module.

Ainsi, de façon avantageuse, le principe de l'invention consiste notamment à la fois à remplacer le verre épais standard d'une épaisseur d'environ 3 mm, habituellement utilisé dans un module photovoltaïque classique, par une première couche plus mince en matériau polymère, et à modifier la face arrière du module photovoltaïque pour prévoir la présence d'une matériau composite de type préimprégné polymère/fibres.

Il est à noter que la première couche et/ou la deuxième couche du module photovoltaïque peuvent être formées en une ou plusieurs parties, à savoir qu'elles peuvent être monocouche ou multicouche.

Le terme « transparent » signifie que le matériau de la première couche formant la face avant du module photovoltaïque est au moins partiellement transparent à la lumière visible, laissant passer au moins environ 80 % de cette lumière.

En outre, par le terme « encapsulant » ou « encapsulé », il faut comprendre que la pluralité de cellules photovoltaïques est disposée dans un volume, par exemple hermétiquement clos vis-à-vis des liquides, au moins en partie formé par au moins deux couches de matériau(x) d'encapsulation, réunies entre elles après lamination pour former l'ensemble encapsulant.

En effet, initialement, c'est-à-dire avant toute opération de lamination, l'ensemble encapsulant est constitué par au moins deux couches de matériau(x) d'encapsulation, dites couches de cœur, entre lesquelles la pluralité de cellules photovoltaïques est encapsulée. Toutefois, pendant l'opération de lamination des couches, les couches de matériau d'encapsulation fondent pour ne former, après l'opération de lamination, qu'une seule couche (ou ensemble) solidifiée dans laquelle sont noyées les cellules photovoltaïques.

Grâce à l'invention, il peut ainsi être possible d'obtenir un nouveau type de module photovoltaïque ultra-léger et flexible. De plus, par l'utilisation d'une face avant en polymère d'épaisseur inférieure à 50 µm, le module photovoltaïque selon l'invention conserve des performances électriques identiques, voire meilleures que celles d'un module standard. De plus, par l'utilisation d'une face arrière en composite préimprégné polymère/fibres, le module photovoltaïque selon l'invention présente d'excellentes propriétés mécaniques et thermomécaniques tout en conservant de la flexibilité sans dégradation des cellules photovoltaïques sous contrainte de flexion. Notamment, il peut accepter des rayons de courbure d'environ 50 cm, voire même 20 cm dans certains cas, sans dégradation des cellules. En outre, notamment par la réduction des épaisseurs de ses éléments constitutifs, le module photovoltaïque selon l'invention peut permettre d'atteindre des poids surfaciques requis inférieurs à 1 kg/m², notamment inférieurs à 800 g/m², et tout particulièrement inférieurs à 600 g/m², le rendant par définition ultra-léger.

Le module photovoltaïque selon l'invention peut en outre comporter l'une ou plusieurs des caractéristiques suivantes prises isolément ou suivant toutes combinaisons techniques possibles.

La deuxième couche peut former la face arrière du module photovoltaïque. Toutefois, elle peut également être interposée entre l'ensemble encapsulant et au moins une couche supplémentaire, par exemple de protection, qui formera alors la face arrière du module.

La deuxième couche peut en particulier présenter une épaisseur comprise entre 50 µm et 80 µm.

La deuxième couche peut être discontinue de manière à réduire encore le poids surfacique lié à cette couche tout en conservant les propriétés mécaniques du module photovoltaïque. En particulier, la deuxième couche peut comporter un ou plusieurs trous, correspondant notamment à un ou plusieurs enlèvements de matière, notamment formés au niveau d'une ou plusieurs cellules photovoltaïques. En cas de discontinuité, le recouvrement total de la surface de la deuxième couche est préférentiellement supérieur à 30 %.

Ledit au moins un matériau composite de type préimprégné peut comporter un taux d'imprégnation de résine polymère compris entre 30 et 70 % en masse.

Ledit au moins un matériau composite de la deuxième couche peut être un préimprégné à base de résine polymère et de fibres, le polymère étant choisi parmi le polyester, l'époxy et/ou l'acrylique, entre autres, et les fibres étant choisies parmi les fibres de verre, de carbone et/ou d'aramide, entre autres.

Ledit au moins un matériau polymère de la première couche peut être choisi parmi : le polycarbonate (PC), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytetrafluoroéthylène (PTFE), le polychlorotrifluoroéthylène (PCTFE), et/ou l'éthylène propylène fluoré (FEP).

Par ailleurs, le module photovoltaïque présente avantageusement un poids surfacique inférieur à 1 kg/m², notamment inférieur à 800 g/m², notamment encore inférieur à 600 g/m².

De plus, l'ensemble encapsulant peut présenter une épaisseur maximale comprise entre 20 µm et 100 µm, et de préférence comprise entre 50 µm et 75 µm.

L'ensemble encapsulant peut être formé par au moins une couche comportant au moins un matériau d'encapsulation de type polymère choisi parmi : les copolymères d'acides, les ionomères, le poly(éthylène-acétate de vinyle) (EVA), les acétals de vinyle , tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'a-oléfines et des α-, β-esters d'acide carboxylique à éthylénique, tels que les copolymères éthylène-acrylate de méthyle et les copolymères éthylène-acrylate de butyle, les élastomères de silicone et/ou les résines époxy, entre autres.

De préférence, l'ensemble encapsulant peut être réalisé à partir de deux couches en matériau(x) polymère(s), notamment deux couches de ionomère, dont le module de Young est très supérieur à celui du poly(éthylène-acétate de vinyle) (EVA) mais toujours compris entre 2 et 400 MPa à température ambiante permettant de meilleures propriétés mécaniques, entre lesquelles sont disposées les cellules photovoltaïques, chaque couche présentant une épaisseur inférieure à 75 µm, et de préférence inférieure à 50 µm.

Les cellules photovoltaïques peuvent être choisies parmi : des cellules photovoltaïques homojonction ou hétérojonction à base de silicium monocristallin (c-Si) et/ou multi-cristallin (mc-Si), et/ou des cellules photovoltaïques de type IBC (pour « Interdigitated Back Contact» en anglais), et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS), entre autres.

Par ailleurs, les cellules photovoltaïques peuvent présenter une épaisseur comprise entre 1 et 300 µm, notamment entre 1 et 200 µm, et avantageusement entre 70 µm et 160 µm.

Le module photovoltaïque peut en outre comporter une boîte de jonction, destinée à recevoir le câblage nécessaire à l'exploitation du module photovoltaïque.

En outre, l'espacement entre deux cellules photovoltaïques voisines, ou encore consécutives ou adjacentes, peut être supérieur ou égal à 1 mm, notamment compris entre 1 et 30 mm, et de préférence égal à 2 mm.

De plus, l'épaisseur du ou des rubans d'interconnexion des cellules photovoltaïques, et ceux utilisés pour interconnecter les guirlandes de cellules (ou « strings » selon la dénomination courante en anglais), a été adaptée pour être compatible avec le procédé de lamination et la faible épaisseur de l'encapsulant. Par exemple, dans le cas de cellules à contact face avant-face arrière, l'épaisseur des rubans d'interconnexion de telles cellules est avantageusement réduite d'au moins 50 % par rapport à celle de rubans utilisés dans un module standard. Les rubans d'interconnexion de telles cellules peuvent présenter une épaisseur inférieure à 100 µm et une largeur inférieure à 3 mm. Pour les rubans d'interconnexion de « string », l'épaisseur est avantageusement strictement inférieure à 200 µm et la largeur inférieure à 5 mm.

De plus, le module photovoltaïque peut comporter des composants électroniques tels que des diodes de bypass, à l'intérieur du laminé photovoltaïque.

De plus, l'invention a encore pour objet, selon un autre de ses aspects, un procédé de réalisation d'un module photovoltaïque tel que défini précédemment, caractérisé en ce qu'il comporte l'étape de lamination à chaud, à une température comprise entre 130°C et 170°C, notamment de l'ordre de 150°C, et pendant une durée du cycle de lamination d'au moins 10 minutes, notamment comprise entre 10 et 20 minutes, des couches constitutives du module photovoltaïque.

De plus, le procédé peut comporter l'étape consistant à laminer les couches constitutives du module photovoltaïque entre deux couches antiadhésives et amortissantes.

Le module photovoltaïque et le procédé de réalisation selon l'invention peuvent comporter l'une quelconque des caractéristiques précédemment énoncées, prises isolément ou selon toutes combinaisons techniquement possibles avec d'autres caractéristiques.

### BRÈVE DESCRIPTION DES DESSINS

L'invention pourra être mieux comprise à la lecture de la description détaillée qui va suivre, d'exemples de mise en œuvre non limitatifs de celle-ci, ainsi qu'à l'examen des figures, schématiques et partielles, du dessin annexé, sur lequel :
- la figure 1 représente, en coupe, un exemple classique de module photovoltaïque comportant des cellules photovoltaïques cristallines,
- la figure 1A représente une variante de réalisation de l'exemple de la figure 1 dans laquelle les cellules photovoltaïques sont de type IBC,
- la figure 2 représente, en vue éclatée, le module photovoltaïque de la figure 1,
- la figure 3 illustre, en coupe et en vue éclatée, un exemple de réalisation d'un module photovoltaïque conforme à l'invention,
- la figure 4 illustre, en coupe et en vue éclatée, une configuration d'un module photovoltaïque conforme à l'invention lors d'une étape de fabrication du module,
- la figure 5 illustre, selon une vue partielle du dessous, une variante de réalisation de la deuxième couche d'un module photovoltaïque conforme à l'invention, et
- la figure 6 illustre, en coupe et en vue éclatée, une variante de réalisation conforme à l'invention du module photovoltaïque de la figure 3.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Les figures 1 et 2 ont déjà été décrites dans la partie relative à l'état de la technique antérieure.

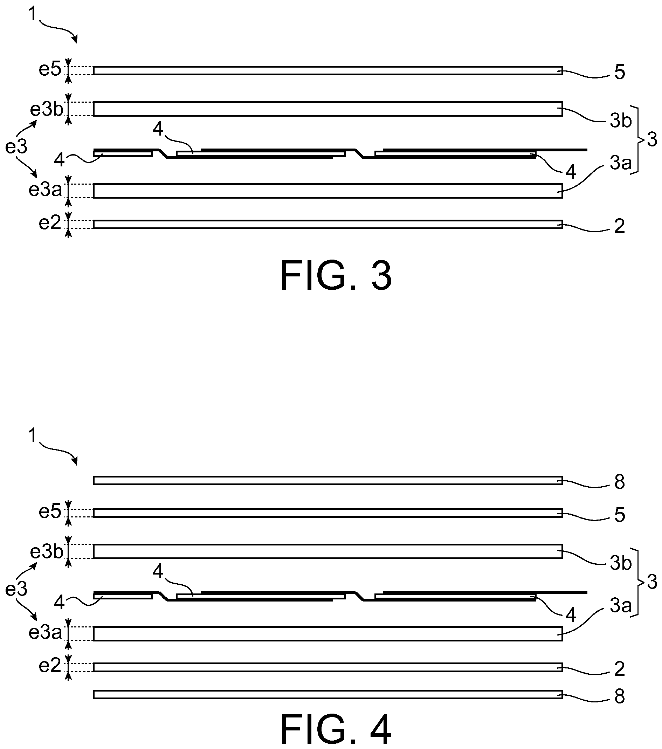

Les figures 3 et 4 illustrent, en coupe et en vue éclatée, des modes de réalisation de modules photovoltaïque 1 conformes à l'invention.

On considère ici que les cellules photovoltaïques 4, interconnectées par des rubans en cuivre étamé soudés, sont des cellules « cristallines », c'est-à-dire qu'elles comportent du silicium mono ou multicristallin, et qu'elles présentent une épaisseur comprise entre 1 et 250 µm.

De plus, l'ensemble encapsulant 3 est choisi pour être réalisé à partir de deux couches de ionomère entre lesquelles sont disposées les cellules photovoltaïques 4, chaque couche étant d'épaisseur inférieure à 50 µm.

De façon avantageuse, l'invention prévoit un choix spécifique pour les matériaux formant les faces avant et arrière du module photovoltaïque 1, de sorte à obtenir un module photovoltaïque 1 ultra-léger, de poids surfacique inférieur à 1 kg/m², et préférentiellement inférieur à 0,8 kg/m², voire 0,6 kg/m².

Bien entendu, ces choix ne sont nullement limitatifs.

On se réfère tout d'abord à la figure 3 qui illustre, en coupe et en vue éclatée, un exemple de réalisation d'un module photovoltaïque 1 conforme à l'invention.

Il est à noter que la figure 3 correspond à une vue éclatée du module photovoltaïque 1 avant l'étape de lamination du procédé selon l'invention. Une fois l'étape de lamination réalisée, assurant un pressage à chaud et sous vide, les différentes couches sont en réalité superposées les unes aux autres.

Le module photovoltaïque 1 comporte ainsi une première couche 2 en un film d'au moins un matériau polymère, d'épaisseur e2 inférieure à 50 µm, formant la face avant du module photovoltaïque 1 et destinée à recevoir un flux lumineux, une pluralité de cellules photovoltaïques 4 disposées côte à côte et reliées électriquement entre elles, et un ensemble encapsulant 3 la pluralité de cellules photovoltaïques 4.

Le matériau polymère de la première couche 2 peut être choisi parmi : le polycarbonate (PC), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le Polychlorotrifluoroéthylène (PCTFE) et/ou l'éthylène propylène fluoré (FEP).

Par ailleurs, alors que la face arrière d'un module photovoltaïque traditionnel est classiquement constituée d'un empilement multicouche polymère de type Tedlar^{®}/ polytéréphtalate d'éthylène (PET)/Tedlar^{®} (ou encore TPT) d'épaisseur de l'ordre de 300 µm, le module photovoltaïque 1 comporte une deuxième couche 5 formant la face arrière du module photovoltaïque 1, constituée par un matériau composite de type préimprégné polymère/fibres continues avec un grammage total inférieur à 150 g/m². De plus, la trame en tissu du préimprégné a une épaisseur inférieure à 50 µm, et le taux d'imprégnation de résine polymère est compris entre 30 et 70 % en masse.

Le matériau composite de la deuxième couche 5 peut être un préimprégné à base de résine polymère et de fibres, le polymère étant choisi parmi le polyester, l'époxy et/ou l'acrylique, et les fibres étant choisies parmi les fibres de verre, de carbone et/ou d'aramide.

La deuxième couche 5 peut présenter une épaisseur e5 comprise entre 50 µm et 80 µm.

En outre, l'ensemble encapsulant 3 présente une épaisseur totale e3 qui est inférieure à 150 µm, et préférentiellement comprise entre 20 et 100 µm.

L'ensemble encapsulant 3 peut être réalisé à partir d'au moins un matériau polymère choisi parmi : les copolymères d'acides, les ionomères, le poly(éthylène-acétate de vinyle) (EVA), les acétals de vinyle, tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'a-oléfines et des α-, β- esters d'acide carboxylique à éthylénique, tels que les copolymères éthylène-acrylate de méthyle et les copolymères éthylène-acrylate de butyle, les élastomères de silicone et/ou les résines époxy. Il peut notamment être réalisé à partir de deux couches polymère 3a et 3b, notamment deux couches de poly(éthylène-acétate de vinyle) (EVA), entre lesquelles sont disposées les cellules photovoltaïques 4. Chaque couche 3a, 3b peut présenter une épaisseur e3a, e3b inférieure à 50 µm.

Par ailleurs, les cellules photovoltaïques 4 peuvent être choisies parmi : des cellules photovoltaïques homojonction ou hétérojonction à base de silicium monocristallin (c-Si) et/ou multi-cristallin (mc-Si), et/ou des cellules photovoltaïques de type IBC, et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS). Leur épaisseur est comprise entre 1 et 300 µm, et notamment entre 1 et 200 µm.

La réalisation du module photovoltaïque 1 est effectuée en une seule étape de lamination à chaud, à une température comprise entre 130°C et 170°C, et notamment de l'ordre de 150°C, et pendant une durée du cycle de lamination d'au moins 10 minutes, et notamment comprise entre 10 et 20 minutes, des couches constitutives 2, 3, 4, 5 formant le stack du module photovoltaïque 1.

Toutefois, compte-tenu de la faible épaisseur de l'ensemble encapsulant 3, il est souhaitable de pouvoir laminer ce stack entre deux feuilles antiadhésives et amortissantes ; compatibles avec le procédé de lamination à chaud ; afin d'éviter toute casse des cellules photovoltaïques durant l'étape de pression, cette casse étant liée à la surépaisseur des rubans de cuivre sur les cellules photovoltaïques 4.

Ainsi, la figure 4 représente une configuration analogue à celle de la figure 3 d'un module photovoltaïque 1 mais avec la présence de deux couches antiadhésives et amortissantes 8 de part et d'autre du stack pour éviter toute casse des cellules photovoltaïques 4.

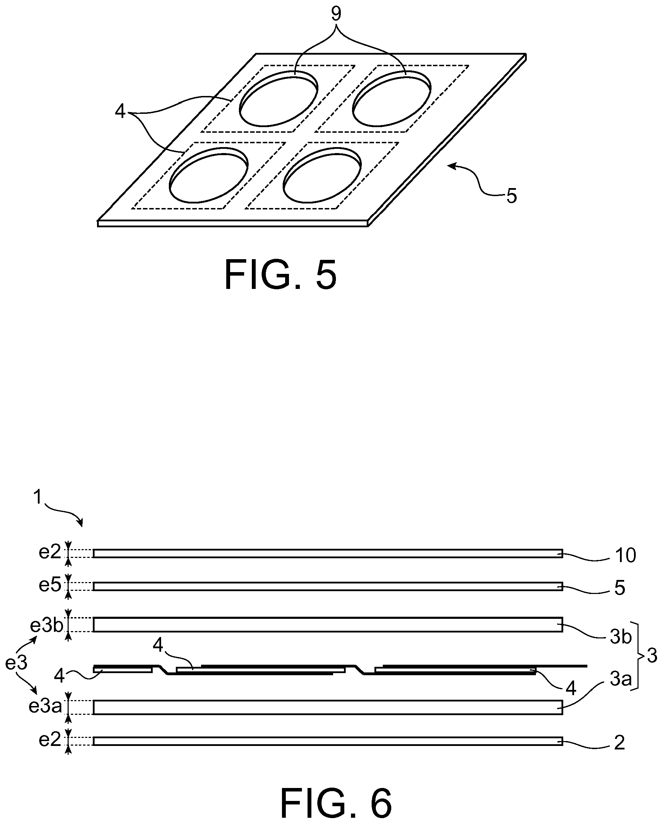

Par ailleurs, la figure 5 illustre, selon une vue partielle du dessous, une variante de réalisation de la deuxième couche 5 d'un module photovoltaïque 1 conforme à l'invention.

Cette variante illustre le fait que la deuxième couche 5, sous forme de préimprégné, peut être discontinue de manière à réduire encore le poids surfacique lié à cette couche 5 tout en conservant les propriétés mécaniques du module photovoltaïque 1.

Ainsi, la deuxième couche 5 comporte des enlèvements de matière formant des trous 9 situés au niveau des cellules photovoltaïques 4. Cet enlèvement de matière se fait sous les cellules photovoltaïques 4, représentées en traits pointillés, qui correspondent à des zones où la résistance mécanique est déjà assurée par ces cellules 4. Autrement dit, la matière du préimprégné formé par la deuxième couche 5 est retirée sous les cellules 4 mais conservée entre les cellules 4 et sur les bords de la couche 5.

### Exemples de réalisation particuliers

On va maintenant décrire deux exemples de réalisation particuliers A et B de modules photovoltaïques 1 conformes à l'invention.

Les deux exemples A et B ont été réalisés avec les mêmes matériaux d'encapsulation mais avec des cellules photovoltaïques différentes :
Dans le premier exemple A, les cellules photovoltaïques 4 comprennent 24 cellules hétérojonction à base de silicium amorphe et monocristallin d'épaisseur de l'ordre de 115 µm.

Dans le deuxième exemple B, les cellules photovoltaïques 4 comprennent 30 cellules de type IBC d'épaisseur de l'ordre de 160 µm.

Par ailleurs, pour ces deux exemples A et B, les couches constitutives sont les suivantes :
La première couche 2 formant la face avant est un film d'éthylène chlorotrifluoroéthylène (ECTFE) de type ECT 025 de la société Rayotec, d'épaisseur de l'ordre de 25 µm.

Les couches d'encapsulant 3a et 3b sont des films de ionomères obtenus à partir de la gamme Jurasol commercialisée par la société Juraplast, d'épaisseur de l'ordre de 50 µm.

La deuxième couche 5 formant la face arrière est un film composite préimprégné de type tissu de verre imprégné par une résine époxy tel que Hexply M77 de la société Hexcel.

Pour chaque exemple A et B, le module photovoltaïque est mis en œuvre en une seule étape de lamination à chaud sous vide. Durant cette étape, il est souhaitable de cuire correctement la face arrière formée par la deuxième couche 5 afin d'obtenir les propriétés mécaniques désirées. Aussi, le programme de lamination à chaud a été optimisé (température, pression, durée, ...) afin d'obtenir une cuisson du matériau composite suffisante sans défaut visuel, ni casse de cellules photovoltaïques 4. Cette réticulation est vérifiée avec une mesure de la transition vitreuse par DSC (pour « Differential Scanning Calorimetry » en anglais).

De plus, comme décrit en référence à la figure 4 précédemment, afin d'éviter la casse des cellules photovoltaïques 4, le module photovoltaïque 1 est laminé entre deux feuilles antiadhésives et amortissantes 8, d'épaisseur de l'ordre de 0,50 mm.

Pour les deux exemples de réalisation A et B, on obtient avantageusement des modules photovoltaïques 1 de poids surfacique inférieur à 800 g/m² et de puissance lumineuse supérieure à 180 W/m².

Par ailleurs, de façon avantageuse, pour ces deux exemples de réalisation A et B, l'imagerie par électroluminescence après mise en œuvre n'a montré aucune dégradation des cellules photovoltaïques 4, même après flexion ou courbure inférieure à 50 cm, ce qui a confirmé ainsi la compatibilité des nouveaux matériaux utilisés avec un procédé classique de lamination à chaud pour la fabrication de modules photovoltaïques 1. Les performances électriques des modules photovoltaïques 1 sont identiques, voire meilleures, que leurs équivalents en configuration standard grâce à la meilleure transparence optique des matériaux utilisés.

De plus, les tenues en vieillissement accéléré en enceinte de cyclage thermique selon la norme terrestre IEC 61215 ont été démontrées sur plus de 600 cycles.

Par ailleurs, la figure 6 illustre une variante de réalisation conforme à l'invention du module photovoltaïque 1 de la figure 3.

Ce module de la figure 6 peut comporter toutes les caractéristiques décrites précédemment, et notamment celles en lien avec les figures 3 à 5 qui ne seront donc pas décrites de nouveau.

Toutefois, dans cet exemple, le module photovoltaïque 1 comporte une couche additionnelle 10 formant la face arrière du module photovoltaïque 1, la deuxième couche 5 étant située entre la couche additionnelle 10 et l'ensemble encapsulant 3.

Cette couche additionnelle 10 est constituée par le même matériau que celui constituant la première couche 2 formant la face avant du module photovoltaïque 1. Avantageusement, ce matériau correspond à de l'éthylène chlorotrifluoroéthylène (ECTFE), également connu sous le nom Halar^{®}.

Par ailleurs, la couche additionnelle 10 présente une épaisseur inférieure, ou égale dans cet exemple de la figure 6, à l'épaisseur e2 de la première couche 2. La couche additionnelle 10 permet avantageusement de réaliser une isolation diélectrique du module 1.

Bien entendu, l'invention n'est pas limitée aux exemples de réalisation qui viennent d'être décrits. Diverses modifications peuvent y être apportées par l'homme du métier.

## Revendications

1. Module photovoltaïque (1) comportant :
- une première couche (2) transparente formant la face avant du module photovoltaïque (1), destinée à recevoir un flux lumineux,
- une pluralité de cellules photovoltaïques (4) disposées côte à côte et reliées électriquement entre elles,
- un ensemble encapsulant (3) la pluralité de cellules photovoltaïques (4),
- une deuxième couche (5), l'ensemble encapsulant (3) et la pluralité de cellules photovoltaïques (4) étant situés entre les première (2) et deuxième (5) couches, où la première couche (2) comporte au moins un matériau polymère et présente une épaisseur (e2) inférieure à 50 µm,
- une couche additionnelle (10) formant la face arrière du module photovoltaïque (1), la deuxième couche (5) étant située entre la couche additionnelle (10) et l'ensemble encapsulant (3), où la deuxième couche (5) présente un poids surfacique inférieur à 150 g/m², l'ensemble encapsulant (3) présente une épaisseur maximale (e3) inférieure à 150 µm, et la
couche additionnelle (10) présente une épaisseur inférieure ou égale à celle de la première couche (2), **caractérisé en ce que** la courche additionnelle (19) est constituée par le même matériau que celui constituant la première couche (2) formant la face avant du module photovoltaïque (1), et **en ce que** la deuxième couche (5) comporte au moins un matériau composite de type préimprégné à base de résine polymère et fibres.

2. Module selon la revendication 1, **caractérisé en ce que** ledit au moins un matériau composite de type préimprégné comporte un taux d'imprégnation de résine polymère compris entre 30 et 70 % en masse.

3. Module selon la revendication 1 ou 2, **caractérisé en ce que** la deuxième couche (5) est discontinue, comportant notamment un ou plusieurs trous (9), notamment formés au niveau d'une ou plusieurs cellules photovoltaïques (4).

4. Module selon l'une des revendications précédentes, **caractérisé en ce que** ledit au moins un matériau composite de la deuxième couche (5) est un préimprégné à base de résine polymère et de fibres, le polymère étant choisi parmi le polyester, l'époxy et/ou l'acrylique, et les fibres étant choisies parmi les fibres de verre, de carbone et/ou d'aramide.

5. Module selon l'une quelconque des revendications précédentes, **caractérisé en ce que** ledit au moins un matériau polymère de la première couche (2) est choisi parmi : le polycarbonate (PC), le polyméthacrylate de méthyle (PMMA), le polytéréphtalate d'éthylène (PET), le polyamide (PA), un polymère fluoré, notamment le polyfluorure de vinyle (PVF) ou le polyfluorure de vinylidène (PVDF), l'éthylène tétrafluoroéthylène (ETFE), l'éthylène chlorotrifluoroéthylène (ECTFE), le polytétrafluoroéthylène (PTFE), le Polychlorotrifluoroéthylène (PCTFE) et/ou l'éthylène propylène fluoré (FEP).

6. Module selon l'une quelconque des revendications précédentes, **caractérisé en ce qu'**il présente un poids surfacique inférieur à 1 kg/m², notamment inférieur à 800 g/m², notamment encore inférieur à 600 g/m².

7. Module selon l'une quelconque des revendications précédentes, **caractérisé en ce que** l'ensemble encapsulant (3) présente une épaisseur maximale (e3) comprise entre 20 µm et 100 µm, et de préférence entre 50 µm et 75 µm.

8. Module selon l'une quelconque des revendications précédentes, **caractérisé en ce que** l'ensemble encapsulant (3) est formé par au moins une couche comportant au moins un matériau d'encapsulation de type polymère choisi parmi : les copolymères d'acides, les ionomères, le poly(éthylène-acétate de vinyle) (EVA), les acétals de vinyle , tels que les polyvinylbutyrals (PVB), les polyuréthanes, les chlorures de polyvinyle, les polyéthylènes, tels que les polyéthylènes linéaires basse densité, les polyoléfines élastomères de copolymères, les copolymères d'a-oléfines et des α-, β-esters d'acide carboxylique à éthylénique, tels que les copolymères éthylène-acrylate de méthyle et les copolymères éthylène-acrylate de butyle, les élastomères de silicone et/ou les résines époxy.

9. Module selon l'une quelconque des revendications précédentes, **caractérisé en ce que** les cellules photovoltaïques (4) sont choisies parmi : des cellules photovoltaïques homojonction ou hétérojonction à base de silicium monocristallin (c-Si) et/ou multi-cristallin (mc-Si), et/ou des cellules photovoltaïques de type IBC, et/ou des cellules photovoltaïques comprenant au moins un matériau parmi le silicium amorphe (a-Si), le silicium microcristallin (µC-Si), le tellurure de cadmium (CdTe), le cuivre-indium séléniure (CIS) et le cuivre-indium/gallium diséléniure (CIGS).

10. Module selon l'une quelconque des revendications précédentes, **caractérisé en ce que** les cellules photovoltaïques (4) présentent une épaisseur comprise entre 1 et 300 µm, notamment entre 1 et 200 µm, notamment entre 70 µm et 160 µm.

11. Module selon l'une quelconque des revendications précédentes, **caractérisé en ce que** la couche additionnelle (10) est constituée par le même matériau que celui constituant la première couche (2) formant la face avant du module photovoltaïque (1), ce matériau étant de l'éthylène chlorotrifluoroéthylène (ECTFE).

12. Procédé de réalisation d'un module photovoltaïque (1) selon l'une quelconque des revendications précédentes, **caractérisé en ce qu'**il comporte l'étape de lamination à chaud, à une température comprise entre 130°C et 170°C, notamment de l'ordre de 150°C, et pendant une durée du cycle de lamination d'au moins 10 minutes, notamment comprise entre 10 et 20 minutes, des couches constitutives (2, 3, 4, 5) du module photovoltaïque (1).

13. Procédé selon la revendication 12, **caractérisé en ce qu'**il comporte l'étape consistant à laminer les couches constitutives (2, 3, 4, 5) du module photovoltaïque (1) entre deux couches antiadhésives et amortissantes (8).

## Patentansprüche

1. Photovoltaisches Modul (1), Folgendes umfassend:
- eine erste transparente Schicht (2), die die Vorderseite des photovoltaischen Moduls (1) bildet, dafür ausgelegt, einen Lichtstrom aufzunehmen,
- eine Vielzahl von photovoltaischen Zellen (4), die nebeneinander angeordnet und elektrisch miteinander verbunden sind,
- eine Einkapselungseinheit (3) der Vielzahl von photovoltaischen Zellen (4),
- eine zweite Schicht (5), wobei sich die Einkapselungseinheit (3) und die Vielzahl von photovoltaischen Zellen (4) zwischen der ersten (2) und der zweiten (5) Schicht befinden, wobei die erste Schicht (2) wenigstens ein Material aufweist, das polymerisch ist und eine Stärke (e2) geringer als 50 µm aufweist,
- eine zusätzliche Schicht (10), die die Rückseite des photovoltaischen Moduls (1) bildet, wobei sich die zweite Schicht (5) zwischen der zusätzlichen Schicht (10) und der Einkapselungseinheit (3) befindet, wobei die zweite Schicht (5) ein Oberflächengewicht geringer als 150 g/m² aufweist,
wobei die Einkapselungseinheit (3) eine Maximalstärke (e3) geringer als 150 µm aufweist,
und die zusätzliche Schicht (10) eine Stärke geringer oder gleich derjenigen der ersten Schicht (2) aufweist, **dadurch gekennzeichnet, dass** die zusätzliche Schicht (19) aus dem gleichen Material konstituiert ist wie demjenigen, das die erste Schicht (2) konstituiert, die die Vorderseite des photovoltaischen Moduls (1) bildet, und dadurch, dass die zweite Schicht (5) wenigstens ein Verbundmaterial des vorimprägnierten Typs auf Basis von polymerischem Harz und Fasern umfasst.

2. Modul nach Anspruch 1, **dadurch gekennzeichnet, dass** das wenigstens eine Verbundmaterial vom vorimprägnierten Typ einen Imprägnierungsgrad mit polymerischem Harz zwischen 30 und 70 Gew.-% umfasst.

3. Modul nach Anspruch 1 oder 2, **dadurch gekennzeichnet, dass** die zweite Schicht (5) diskontinuierlich ist, umfassend insbesondere ein oder mehrere Löcher (9), insbesondere ausgebildet auf der Ebene von einer oder mehreren photovoltaischen Zellen (4).

4. Modul nach einem der vorhergehenden Ansprüche, **dadurch gekennzeichnet, dass** das wenigstens eine Verbundmaterial der zweiten Schicht (5) auf der Basis von polymerischem Harz und Fasern vorimprägniert ist, wobei das Polymer ausgewählt ist aus Polyester, Epoxid und/oder Acryl, und wobei die Fasern ausgewählt sind aus Glas-, Kohlenstoff- und/oder Aramidfasern.

5. Modul nach einem der vorhergehenden Ansprüche, **dadurch gekennzeichnet, dass** das wenigstens eine Polymermaterial der ersten Schicht (2) ausgewählt ist aus: Polycarbonat (PC), Polymethylmethacrylat (PMMA), Polyethylenterephthalat (PET), Polyamid (PA), einem Fluorpolymer, insbesondere Polyvinylfluorid (PVF) oder Polyvinylidenfluorid (PVDF), Ethylen-Tetrafluorethylen (ETFE), Ethylen-Chlortrifluorethylen (ECTFE), Polytetrafluorethylen (PTFE), Polychlorotrifluoroethylen (PCTFE) und/oderTetrafluorethylen-Hexafluorpropylen (FEP).

6. Modul nach einem der vorhergehenden Ansprüche, **dadurch gekennzeichnet, dass** es ein Oberflächengewicht geringer als 1 kg/m² aufweist, insbesondere geringer als 800 g/m², insbesondere noch geringer als 600 g/m².

7. Modul nach einem der vorhergehenden Ansprüche, **dadurch gekennzeichnet, dass** die Einkapselungseinheit (3) eine maximale Stärke (e3) zwischen 20 um und 100 µm aufweist und bevorzugt zwischen 50 µm und 75 µm.

8. Modul nach einem der vorhergehenden Ansprüche, **dadurch gekennzeichnet, dass** die Einkapselungseinheit (3) aus wenigstens einer Schicht gebildet ist, die wenigstens ein Einkapselungmaterial umfasst vom polymerischen Typ ausgewählt aus: Säurecopolymeren, lonomeren, Poly-(Ethylen-Vinylacetat) (EVA), Vinlyacetalen wie Polyvinylbutyralen (PVB), Polyurethanen, Ponlyvinylchloriden, Polyethylenen wie linearen Polyethylenen mit geringer Dichte, Copolymer-Elastomer-Polyolefinen, α-Olefin-Copolymeren und α-, β-Estern von Carbonsäure bis Ethylensäure wie Ethylmethacrylatcopolymeren und Ethylbutylacrylatcopolymeren, Silikonelastomeren und/oder Epoxidharzen.

9. Modul nach einem der vorhergehenden Ansprüche, **dadurch gekennzeichnet, dass** die photovoltaischen Zellen (4) ausgewählt sind aus:
photovoltaischen Homoübergangs- oder Heteroübergangs-Zellen auf der Basis von monokristallinem (c-Si) und/oder multikristallinem (mc-Si) Silizium, und/oder photovoltaischen Zellen vom Typ IBC, und/oder photovoltaischen Zellen, die wenigstens ein Material aus amorphem Silizium (a-Si), mikrokristallinem Silizium (µC-Si), Cadmiumtellurid (CdTe), Kupfer-Indium-Selenid (CIS) und Kupfer-Indium/Gallium-Diselenid (CIGS) umfassen.

10. Modul nach einem der vorhergehenden Ansprüche, **dadurch gekennzeichnet, dass** die photovoltaischen Zellen (4) eine Stärke zwischen 1 und 300 µm aufweisen, insbesondere zwischen 1 und 200 µm, insbesondere zwischen 70 µm und 160 µm.

11. Modul nach einem der vorhergehenden Ansprüche, **dadurch gekennzeichnet, dass** die zusätzliche Schicht (10) aus dem gleichen Material konstituiert ist, das die erste Schicht (2) konstituiert, die die Vorderseite des photovoltaischen Moduls (1) bildet, wobei das Material Ethylen-Chlortrifluorethylen (ECTFE) ist.

12. Verfahren zur Umsetzung eines photovoltaischen Moduls (1) nach einem der vorhergehenden Ansprüche, **dadurch gekennzeichnet, dass** es den Schritt der Heißlaminierung umfasst bei einer Temperatur zwischen 130 °C und 170 °C, insbesondere in der Größenordnung von 150 °C, und während einer Dauer des Laminierungszyklus von wenigstens 10 Minuten, insbesondere zwischen 10 und 20 Minuten, der konsekutiven Schichten (2, 3, 4, 5) des photovoltaischen Moduls (1).

13. Verfahren nach Anspruch 12, **dadurch gekennzeichnet, dass** es den Schritt umfasst bestehend aus dem Laminieren der konsekutiven Schichten (2, 3, 4, 5) des photovoltaischen Moduls (1) zwischen zwei antihaftbeschichteten und stoßdämpfenden Schichten (8).

## Claims

1. A photovoltaic module (1) including:
- a first transparent layer (2) forming the front face of the photovoltaic module (1), for receiving a luminous flux,
- a plurality of photovoltaic cells (4) disposed side by side and electrically connected to each other,
- an encapsulant assembly (3) encapsulating the plurality of photovoltaic cells (4),
- a second layer (5), the encapsulant assembly (3) and the plurality of photovoltaic cells (4) being located between the first (2) and second (5) layers,
wherein the first layer (2) includes at least one polymeric material and has a thickness (e2) lower than 50µm,
- an additional layer (10) forming the rear face of the photovoltaic module (1), the second layer (5) being located between the additional layer (10) and the encapsulant assembly (3),
wherein the second layer (5) has a weight per unit area lower than 150g/m²,
the encapsulant assembly (3) has a maximum thickness (e3) lower than 150µm,
and the additional layer (10) has a thickness lower than or equal to that of the first layer (2),
**characterised in that** the additional layer (10) consists of the same material as that making up the first layer (2) forming the front face of the photovoltaic module (1), and **in that** the second layer (5) includes at least one polymeric resin and fibres based-pre-preg-type composite material.

2. The module according to claim 1, **characterised in that** said at least one pre-preg-type composite material has a polymeric resin impregnation rate between 30 and 70 mass %.

3. The module according to claim 1 or 2, **characterised in that** the second layer (5) is discontinuous, especially including one or more holes (9), especially formed at one or more photovoltaic cells (4).

4. The module according to one of the previous claims, **characterised in that** said at least one material composite of the second layer (5) is a polymeric resin and fibres based pre-preg, the polymer being selected from polyester, epoxy and/or acrylic, and the fibres being selected from glass, carbon and/or aramid fibres.

5. The module according to any of the previous claims, **characterised in that** said at least one polymeric material of the first layer (2) is selected from:
polycarbonate (PC), polymethyl methacrylate (PMMA), polyethylene terephthalate (PET), polyamide (PA), a fluorinated polymer, especially polyvinyl fluoride (PVF) or polyvinylidene fluoride (PVDF), ethylene tetrafluoroethylene (ETFE), ethylene chlorotrifluoroethylene (ECTFE), polytetrafluoroethylene (PTFE), polychlorotrifluoroethylene (PCTFE) and/or fluorinated ethylene propylene (FEP).

6. The module according to any of the previous claims, **characterised in that** it has a weight per unit area lower than 1kg/m², especially lower than 800g/m², still especially lower than 600g/m².

7. The module according to any of the previous claims, **characterised in that** the encapsulant assembly (3) has a maximum thickness (e3) between 20µm and 100µm, and preferably between 50µm and 75µm.

8. The module according to any of the previous claims, **characterised in that** the encapsulant assembly (3) is formed by at least one layer including at least one polymer type encapsulation material selected from: acid copolymers, ionomers, poly(ethylene-vinyl acetate) (EVA), vinyl acetals, such as polyvinylbutyrals (PVB), polyurethanes, polyvinyl chlorides, polyethylenes, such as low density linear polyethylenes, copolymer elastomer polyolefins, α-olefin and α,β-ethylenic carboxylic acid ester copolymers, such as ethylene-methyl acrylate copolymers and ethylene-butyl acrylate copolymers, silicone elastomers and/or epoxy resins.

9. The module according to any of the previous claims, **characterised in that** the photovoltaic cells (4) are selected from: single crystal (c-Si) and/or multi-crystalline (mc-Si)-based homojunction or heterojunction photovoltaic cells, and/or IBC-type photovoltaic cells, and/or photovoltaic cells comprising at least one material from amorphous silicon (a-Si), microcrystalline silicon (µC-Si), cadmium telluride (CdTe), copper-indium selenide (CIS) and copper-indium/gallium diselenide (CIGS).

10. The module according to any of the previous claims, **characterised in that** the photovoltaic cells (4) have a thickness between 1 and 300µm, especially between 1 and 200µm, especially between 70µm and 160µm.

11. The module according to any of the previous claims, **characterised in that** the additional layer (10) consists of the same material as that making up the first layer (2) forming the front face of the photovoltaic module (1), this material being ethylene chlorotrifluoroethylene (ECTFE).

12. A method for making a photovoltaic module (1) according to any of the previous claims, **characterised in that** it includes the step of hot laminating, at a temperature between 130°C and 170°C, especially in the order of 150°C, and for a time period of the lamination cycle of at least 10 minutes, especially between 10 and 20 minutes, the constituent layers (2, 3, 4, 5) of the photovoltaic module (1).

13. The method according to claim 12, **characterised in that** it includes the step of laminating the constituent layers (2, 3, 4, 5) of the photovoltaic module (1) between two anti-adhesive damping layers (8).
